# EUROPEAN PATENT APPLICATION

(11) **EP 3 174 209 A1**
(43) Date of publication of application: **31.05.2017**
(21) Application number: 16169102.7
(22) Date of filing: 11.05.2016
(51) Int. Cl.: H03K 19/0175

(54) **DRIVER CIRCUIT FOR SIGNAL TRANSMISSION**

(30) Priority: 30.11.2015 US 201562260723 P; 14.03.2016 US 201615069880
(71) Applicant: MediaTek Inc., Hsin-Chu 300 (TW)
(72) Inventor: WU, Chien-Hua, 104 Jhongshan District, Taipei City (TW); LUO, Yan-Bin, 105 Songshan District, Taipei City (TW)
(74) Representative: Hoefer & Partner Patentanwälte mbB

(57) **Abstract**

A driver circuit (100) for receiving a data input and generating an output signal to a termination element according to at least the first data input is provided. The driver circuit (100) includes a first output terminal, a current mode drive unit (110) and a voltage mode drive unit (120). The current mode drive unit (110) is arranged for selectively outputting a first reference current from the first output terminal to the termination element according to the first data input, and selectively receiving the first reference current through the first output terminal according to the first data input. The voltage mode drive unit (120) is arranged for coupling one of a first reference voltage and a second reference voltage different from the second reference voltage to the first output terminal according to the first data input.

## Description

The present invention relates to a driver circuit for signal transmission according to the pre-characterizing clause of claim 1.

Traditional serializer/deserializer (SerDes) designs employ driver circuits including a current mode logic (CML) driver, a voltage mode driver, and an H-bridge current mode driver having a resistor coupled between a differential output terminals (referred to hereinafter as an H-bridge driver). However, the CML driver consumes more power. The voltage mode driver lacks design flexibility and is therefore unsuitable for transmitter (TX) equalizer design. Power efficiency of the H-bridge driver is higher than that of the CML driver but still lower than that of the voltage mode driver.

This in mind, the present invention aims at providing a driver circuit capable of referring to data logic to couple reference voltage(s) and reference current(s) to a terminal element and a related control method thereof for reducing the power consumption and enhancing design flexibility.

This is achieved by a driver circuit according to claim 1. The dependent claims pertain to corresponding further developments and improvements.

As will be seen more clearly from the detailed description following below, the claimed driver circuit for receiving a first data input and generating an output signal to a termination element according to at least the first data input includes a first output terminal, a first current mode drive unit and a first voltage mode drive unit. The first output terminal is arranged for outputting the output signal. The first current mode drive unit is coupled to the first output terminal, and is arranged for generating a first reference current, selectively outputting the first reference current from the first output terminal to the termination element according to the first data input, and selectively receiving the first reference current through the first output terminal according to the first data input, wherein when the first current mode drive unit outputs the first reference current, the first current mode drive unit steers the first reference current to flow into the termination element such that the first reference current outputted from the first current mode drive unit flows through the termination element and is used as at least a portion of a current flowing through the termination element. The first voltage mode drive unit is coupled to the first output terminal, and is arranged for coupling one of a first reference voltage and a second reference voltage to the first output terminal according to the first data input, wherein the first reference voltage is different from the second reference voltage.

In the following, the invention is further illustrated by way of example, taking reference to the accompanying drawings. Thereof:
FIG. 1 is a block diagram illustrating an exemplary driver circuit according to an embodiment of the present invention;
FIG. 2 is a diagram illustrating a first implementation of the driver circuit shown in FIG. 1;
FIG. 3 is a diagram illustrating an exemplary output operation of the driver circuit shown in FIG. 2;
FIG. 4 is a diagram illustrating another exemplary output operation of the driver circuit shown in FIG. 2;
FIG. 5, which is a diagram illustrating a second implementation of the driver circuit shown in FIG. 1;
FIG. 6 is a diagram illustrating an exemplary output operation of the driver circuit shown in FIG. 5;
FIG. 7 is a diagram illustrating another exemplary output operation of the driver circuit shown in FIG. 5;
FIG. 8 is a first alternative design of the driver circuit shown in FIG. 5;
FIG. 9 is a second alternative design of the driver circuit shown in FIG. 5;
FIG. 10 is a third alternative design of the driver circuit shown in FIG. 5;
FIG. 11 is a fourth alternative design of the driver circuit shown in FIG. 5;
FIG. 12 is a fifth alternative design of the driver circuit shown in FIG. 5;
FIG. 13 is a block diagram illustrating an exemplary driver circuit according to an embodiment of the present invention;
FIG. 14 is a diagram illustrating an implementation of the driver circuit shown in FIG. 13;
FIG. 15 is a block diagram illustrating an exemplary driver circuit according to an embodiment of the present invention;
FIG. 16 is a diagram illustrating an implementation of the driver circuit shown in FIG. 15;
FIG. 17 is a diagram illustrating an exemplary driver circuit according to an embodiment of the present invention;
FIG. 18 is a diagram illustrating an exemplary driver circuit according to another embodiment of the present invention;
FIG. 19 is a diagram illustrating an exemplary driver circuit according to another embodiment of the present invention;
FIG. 20 is a diagram illustrating an exemplary driver circuit according to another embodiment of the present invention;
FIG. 21 is a diagram illustrating an exemplary driver circuit according to another embodiment of the present invention; and
FIG. 22 is a diagram illustrating an exemplary driver circuit according to an embodiment of the present invention.

In order to meet low power and high flexibility requirements, the proposed driver circuit may provide a reference current and a plurality of reference voltages, wherein when the reference current is outputted from one of a pair of differential output terminals according to data logic, the reference voltages may be coupled to different output terminals of the pair of differential output terminals, respectively, thus implementing a driver architecture consuming less power. The power consumption of the proposed driver circuit may be even less than that of a voltage mode driver. In addition to a differential driver circuit, the proposed driver control mechanism may be employed in a single-ended driver circuit. Further, the proposed driver control mechanism may be employed in multi-level driver and a transmit finite impulse response (FIR) equalizer. Moreover, the proposed driver circuit may be employed in equalizer architecture due to high design flexibility. To facilitate an understanding of the present invention, an exemplary implementation of a driver circuit of a SerDes transmitter is given in the following for further description of the proposed power control mechanism. However, a person skilled in the art should understand that this is not meant to be a limitation of the present invention.

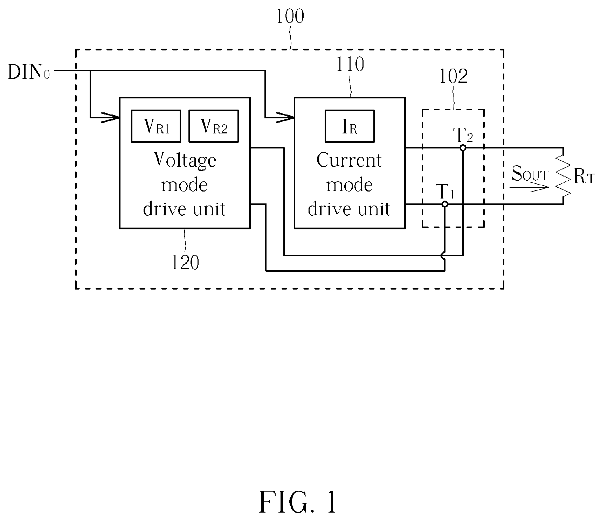

Please refer to FIG. 1, which is a block diagram illustrating an exemplary driver circuit according to an embodiment of the present invention. By way of example but not limitation, the driver circuit 100 may be employed in a SerDes transmitter (not shown in FIG. 1). Specifically, the driver circuit 100 may receive a data input DIN₀and generate an output signal S_{OUT} to a termination element (implemented by a termination resistor R_{T} in this embodiment) according to the data input DIN₀, wherein the termination resistor R_{T} may be located in a SerDes receiver (not shown in FIG. 1). The driver circuit 100 may include a pair of differential output terminals 102 (having an output terminal T₁ and an output terminal T₂), a current mode drive unit 110 and a voltage mode drive unit 120. The output signal S_{OUT} may be regarded as a voltage difference between the output terminal T₁ and the output terminal T₂, and correspond to an output data logic (e.g. a logic "1" corresponding to a positive voltage or a logic "0" corresponding to a negative voltage).

The current mode drive unit 110 is coupled to the pair of differential output terminals 102, and is arranged for generating a reference current I_{R}, wherein the current mode drive unit 110 may output the reference current I_{R} from one of the output terminal T₁ and the output terminal T₂ according to the data input DIN₀, and receive the reference current I_{R} from the other of the output terminal T₁ and the output terminal T₂ according to the data input DIN₀. Specifically, after the reference current I_{R} is outputted from one of the output terminal T₁ and the output terminal T₂, the reference current I_{R} may flow through the termination resistor R_{T} first, and then flows into the current mode drive unit 110 through the other of the output terminal T₁ and the output terminal T₂. In other words, the current mode drive unit 110 may change a direction of the reference current I_{R} through the termination resistor R_{T}, thereby changing respective electric potentials of the output terminal T₁ and the output terminal T₂.

Additionally, in a case where the current mode drive unit 110 outputs the reference current I_{R} from the output terminal T₁ and receives the reference current I_{R} from the output terminal T₂, as a voltage of the output terminal T₁ is greater than a voltage of the output terminal T₂, the output signal S_{OUT} may correspond to a specific output data logic (e.g. a logic "1"). In another case where the current mode drive unit 110 outputs the reference current I_{R} from the output terminal T₂ and receives the reference current I_{R} from the output terminal T₁, the output signal S_{OUT} may correspond to another specific output data logic (e.g. a logic "0") . Please note that a voltage difference between the output terminal T₁ and the output terminal T₂ may be a voltage drop across the termination resistor R_{T} due to the reference current I_{R} flowing therethrough, which implies that an output current of the current mode drive unit 110 may be effectively provided for the SerDes receiver.

The voltage mode drive unit 120 is coupled to the pair of differential output terminals 102, and is arranged for providing a reference voltage V_{R1} and a reference voltage V_{R2} different from the reference voltage V_{R1}, wherein the voltage mode drive unit 120 may couple the reference voltage V_{R1} to one of the output terminal T₁ and the output terminal T₂ according to the data input DIN₀, and couple the reference voltage V_{R2} to the other of the output terminal T₁ and the output terminal T₂ according to the data input DIN₀. Specifically, the reference voltage V_{R1} and the reference voltage V_{R2} may be provided for two output terminals of the pair of differential output terminals 102, respectively, so that the output terminal T₁ and the output terminal T₂ may have different electric potentials to provide an output voltage required by the SerDes receiver.

For example, in a case where the reference voltage V_{R1} is greater than the reference voltage V_{R2}, when the reference voltage V_{R1} is coupled to the output terminal T₁ and the reference voltage V_{R2} is coupled to the output terminal T₂, the output signal S_{OUT} may correspond to a specific output data logic (e.g. a logic "1"); and when the reference voltage V_{R1} is coupled to the output terminal T₂ and the reference voltage V_{R2} is coupled to the output terminal T₁, the output signal S_{OUT} may correspond to another specific output data logic (e.g. a logic "0"). It should be noted that electric potential of one of the output terminal T₁ and the output terminal T₂ may be equal to the reference voltage V_{R1}, and electric potential of the other of the output terminal T₁ and the output terminal T₂ may be equal to the reference voltage V_{R2}, which implies that an output voltage of the voltage mode drive unit 120 may be effectively provided for the pair of differential output terminals 102.

In view of above, the current mode drive unit 110 may provide the output current effectively, and the voltage mode drive unit 120 may provide the output voltage effectively. Hence, a power efficient driver circuit can be provided. For example, in a case where the reference voltage V_{R1} is greater than the reference voltage V_{R2}, when the current mode drive unit 110 outputs the reference current I_{R} from the output terminal T₁ and receives reference current I_{R} from the output terminal T₂ according to the data input DIN₀, the voltage mode drive unit 120 may couple the reference voltage V_{R1} to the output terminal T₁ and couple the reference voltage V_{R2} to the output terminal T₂ according to the data input DIN₀. Hence, when electric potential of one of the output terminal T₁ and the output terminal T₂ is equal to the reference voltage V_{R1}, electric potential of the other of the output terminal T₁ and the output terminal T₂ is equal to the reference voltage V_{R2}, and a voltage difference between the reference voltage V_{R1} and the reference voltage V_{R2} is equal to a voltage drop across the termination resistor R_{T} due to the reference current I_{R} flowing therethrough, a drive current outputted from the driver circuit 100 may be provided by the current mode drive unit 110 only, thus greatly reducing power consumption.

The above is for illustrative purposes only, and is not meant to be a limitation of the present invention. In on implementation, the drive current outputted from the driver circuit 100 may come from the current mode drive unit 110 and the voltage mode drive unit 120. In other words, the drive current outputted from the driver circuit 100 may be a sum of the reference current I_{R} and an output current of the voltage mode drive unit 120, wherein a ratio of the reference current I_{R} to the drive current outputted from the driver circuit 100 may adjusted according to actual requirements/considerations.

Additionally, the reference voltage V_{R1} and/or the reference voltage V_{R2} provided by the voltage mode drive unit 120 may be generated within the driver circuit 100 or generated by a circuit external to driver circuit 100. For example, the voltage mode drive unit 120 may include a voltage generation circuit (not shown in FIG. 1), which is used for generating at least one of the reference voltage V_{R1} and the reference voltage V_{R2}. In another example, at least one of the reference voltage V_{R1} and the reference voltage V_{R2} may be directly provided by a voltage generation circuit external coupled to the driver circuit 100, such as a system power supply or a ground terminal. In other words, the voltage mode drive unit 120 may provide the reference voltage V_{R1} and the reference voltage V_{R2} by coupling a voltage, supplied from an external circuit, to output terminal(s) of a differential pair of output terminals.

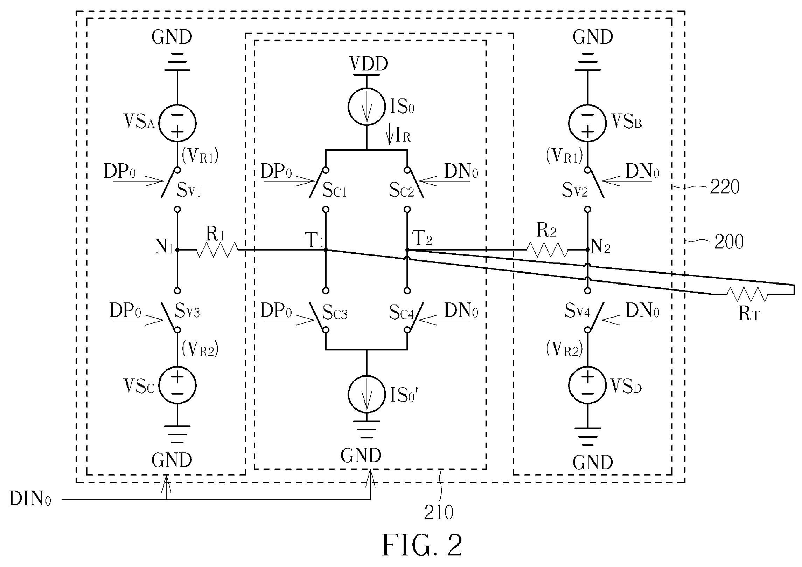

FIG. 2 is a diagram illustrating a first implementation of the driver circuit 100 shown in FIG. 1. In this implementation, the driver circuit 200 may include the output terminals T₁ and T₂ shown in FIG. 1 (i.e. a pair of differential output terminals), a current mode drive unit 210 and a voltage mode drive unit 220, wherein the current mode drive unit 110 and the voltage mode drive unit 120 shown in FIG. 1 may be implemented by the current mode drive unit 210 and the voltage mode drive unit 220, respectively. Additionally, a symbol VDD denotes a direct current (DC) power required by circuit elements, and a symbol GND denotes a reference voltage node (e.g. a common ground).

The current mode drive unit 210 may include a current source IS₀ and a current sink IS₀'. The current source IS₀ may be arranged for generating the reference current I_{R}, and the current sink IS₀' may be arranged for receiving the reference current I_{R}, wherein the current source IS₀ may be coupled to one of the output terminal T₁ and the output terminal T₂ according to the data input DIN₀, and the current sink IS₀' may be coupled to the other of the output terminal T₁ and the output terminal T₂ according to the data input DIN₀.

In this implementation, the current mode drive unit 210 may include further include a plurality of switches S_{C1}-S_{C4}, wherein the switch S_{C1} may be selectively coupled between the current source IS₀ and the output terminal T₁ according to the data input DIN₀; the switch S_{C2} may be selectively coupled between the current source IS₀ and the output terminal T₂ according to the data input DIN₀; the switch S_{C3} may be selectively coupled between the current sink IS₀' and the output terminal T₁ according to the data input DIN₀; and the switch S_{C4} may be selectively coupled between the current sink IS₀' and the output terminal T₂ according to the data input DIN₀. When the switch S_{C1} and the switch S_{C4} are switched on due to the data input DIN₀, the switch S_{C2} and the switch S_{C3} are switched off; and when the switch S_{C1} and the switch S_{C4} are switched off due to the data input DIN₀, the switch S_{C2} and the switch S_{C3} are switched on. Hence, the current source IS₀ may output the reference current I_{R} from one of the output terminal T₁ and the output terminal T₂, and the current sink IS₀' may draw the reference current I_{R} from the other of the output terminal T₁ and the output terminal T₂.

For example, the data input DIN₀ may include a data signal DP₀ and a data signal DN₀, wherein the data signal DP₀ and the data signal DN₀ may be inverted with respect to each other, or non-overlapping signals. The data signal DP₀ may control switch states of the switches S_{C1} and S_{C3}, wherein when one of the switches S_{C1} and S_{C3} is switched on, the other of the switches S_{C1} and S_{C3} is switched off. The data signal DN₀ may control switch states of the switches S_{C2} and S_{C4}, wherein when one of the switches S_{C2} and S_{C4} is switched on, the other of the switches S_{C2} and S_{C4} is switched off. Further, when the switch S_{C1} is switched on due to the data signal DP₀, the switch S_{C2} is switched off due to the data signal DN₀, and when the switch S_{C1} is switched off due to the data signal DP₀, the switch S_{C2} is switched on due to the data signal DN₀.

Based on the aforementioned switch operations, the current source IS₀ may output the reference current I_{R} from one of the output terminal T₁ and the output terminal T₂ according to the data input DIN₀, and current sink IS₀' may draw the reference current I_{R} from the other of the output terminal T₁ and the output terminal T₂ according to the data input DIN₀. Please note that the aforementioned architecture and switch control signals of the current mode drive unit 210 are for illustrative purposes, and are not meant to be limitations of the present invention. For example, the switches S_{C1} and S_{C2} (or the switches S_{C3} and S_{C4}) may be replaced by a three-way switch. As long as the current mode drive unit 210 may output the reference current I_{R} from one of the output terminal T₁ and the output terminal T₂ and receive the reference current I_{R} from the other of the output terminal T₁ and the output terminal T₂ according to the data input DIN₀, other variations and modifications fall within the spirit and scope of the present invention.

The voltage mode drive unit 220 may include a plurality of voltage sources VS_{A}-VS_{D}, a plurality of switches S_{V1}-S_{V4}, and a plurality of impedance elements (implemented by resistors R₁ and R₂ in this implementation). The voltage sources VS_{A} and VS_{B} may be used to generate the reference voltage V_{R1} shown in FIG. 1, and the voltage sources VS_{C} and VS_{D} may be used to generate the reference voltage V_{R2} shown in FIG. 1. The resistor R₁ is coupled between a node N₁ and the output terminal T₁, and the resistor R₂ is coupled between a node N₂ and the output terminal T₂, wherein the node N₁ may be coupled to the reference voltage V_{R1} through the switch S_{V1} or coupled to the reference voltage V_{R2} through the switch S_{V3} according to the data input DIN₀, and the node N₂ may be coupled to the reference voltage V_{R1} through the switch S_{V2} or coupled to the reference voltage V_{R2} through the switch S_{V4} according to the data input DIN₀. To put it differently, the switch S_{V1} maybe selectively coupled between the reference voltage V_{R1} (the voltage source VS_{A}) and the output terminal T₁ (through the resistor R₁) according to the data input DIN₀; the switch S_{V2} may be selectively coupled between the reference voltage V_{R1} (the voltage source VS_{B}) and the output terminal T₂ (through the resistor R₂) according to the data input DIN₀; the switch S_{V3} may be selectively coupled between the reference voltage V_{R2} (the voltage source VS_{C}) and the output terminal T₁ (through the resistor R₁) according to the data input DIN₀; and the switch S_{V4} may be selectively coupled between the reference voltage V_{R2} (the voltage source VS_{D}) and the output terminal T₂ (through the resistor R₂) according to the data input DIN₀.

In this implementation, when the switch S_{V1} and the switch S_{V4} are switched on due to the data input DIN₀, the switch S_{V2} and the switch S_{V3} are switched off; and when the switch S_{V1} and the switch S_{V4} are switched off due to the data input DIN₀, the switch S_{V2} and the switch S_{V3} are switched on. For example, the data signal DP₀ may control switch states of the switches S_{V1} and S_{V3}, wherein when one of the switches S_{V1} and S_{V3} is switched on, the other of the switches S_{V1} and S_{V3} is switched off. Additionally, the data signal DN₀ may control switch states of the switches S_{V2} and S_{V4}, wherein when one of the switches S_{V2} and S_{V4} is switched on, the other of the switches S_{V2} and S_{V4} is switched off. Further, when the switch S_{V1} is switched on due to the data signal DP₀, the switch S_{V2} is switched off due to the data signal DN₀, and when the switch S_{V1} is switched off due to the data signal DP₀, the switch S_{V2} is switched on due to the data signal DN₀.

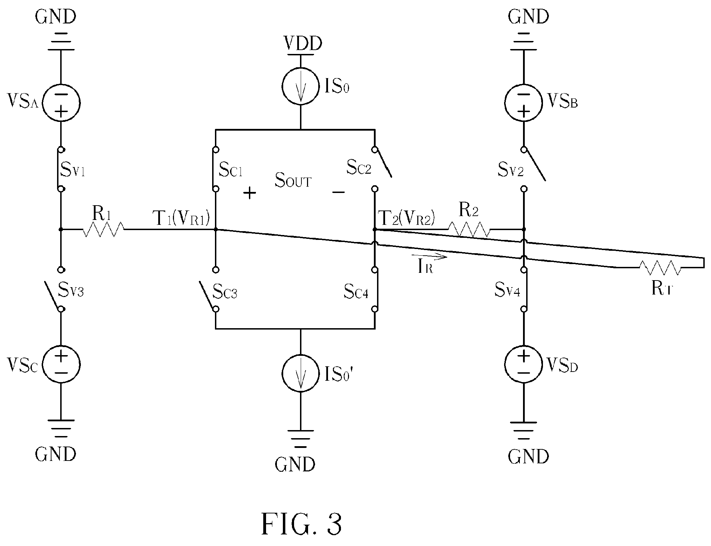

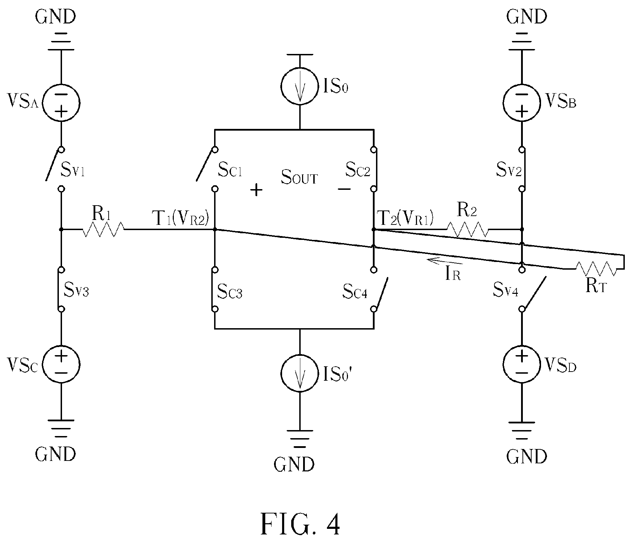

Based on the aforementioned switch operations, one terminal of the resistor R₁ (the node N₁) may be coupled to one of the reference voltage V_{R1} and the reference voltage V_{R2} according to the data input DIN₀, and one terminal of the resistor R₂ (the node N₂) may be coupled to the other of the reference voltage V_{R1} and the reference voltage V_{R2} according to the data input DIN₀. Please refer to FIG. 3 and FIG. 4. FIG. 3 is a diagram illustrating an exemplary output operation of the driver circuit 200 shown in FIG. 2, and FIG. 4 is a diagram illustrating another exemplary output operation of the driver circuit 200 shown in FIG. 2. For illustrative purposes, a voltage difference obtained by subtracting a voltage of the output terminal T₂ from a voltage of the output terminal T₁ is used as the output signal S_{OUT} in the embodiments shown in FIG. 3 and FIG. 4. Hence, when the voltage of the output terminal T₁ is greater than the voltage of the output terminal T₂, the output signal S_{OUT} corresponds to a data logic "1"; and when the voltage of the output terminal T₁ is less than the voltage of the output terminal T₂, the output signal S_{OUT} corresponds to a data logic "0". Additionally, it is assumed that the reference voltage V_{R1} generated by the voltage sources VS_{A} and VS_{B} is greater than the reference voltage V_{R2} generated by the voltage sources VS_{C} and VS_{D}. Please note that the aforementioned definition of the data logic and a magnitude relationship between the reference voltages are for illustrative purposes only, and are not meant to be limitations of the present invention.

In the embodiment shown in FIG. 3, the reference current I_{R} generated from the current source IS₀ may be outputted from the output terminal T₁ to the termination resistor R_{T} through the switch S_{C1}, and then flow into the current sink IS₀' through the output terminal T₂ and the switch S_{C4}. Additionally, the switches S_{V1} and S_{V4} are switched on, allowing the reference voltage V_{R1} (a high voltage) and the reference voltage V_{R2} (a low voltage) to be coupled to the output terminal T₁ and the output terminal T₂ respectively. The output signal S_{OUT} may correspond to a data logic "1". In the embodiment shown in FIG. 4, the reference current I_{R} generated from the current source IS₀ may be outputted from the output terminal T₂ to the termination resistor R_{T} through the switch S_{C2}, and then flow into the current sink IS₀' through the output terminal T₁ and the switch S_{C3}. The switches S_{V2} and S_{V3} are switched on, allowing the reference voltage V_{R1} and the reference voltage V_{R2} to be coupled to the output terminal T₂ and the output terminal T₁ respectively. The output signal S_{OUT} may correspond to a data logic "0".

It should be noted that, if a voltage difference between respective voltages provided by the voltage sources VS_{A} and VS_{D} is equal to a voltage drop across the termination resistor R_{T} due to the reference current I_{R} flowing through the termination resistor R_{T}, no current flows through the resistors R₁ and R₂. In other words, the voltage mode drive unit 220 may provide electric potentials for the output terminal T₁ and the output terminal T₂ without causing a power loss. Further, as the output terminal T₁ and the output terminal T₂ are a pair of differential output terminals, the resistor R₁ and the resistor R₂ may have the same impedance value to improve the quality of differential output signals.

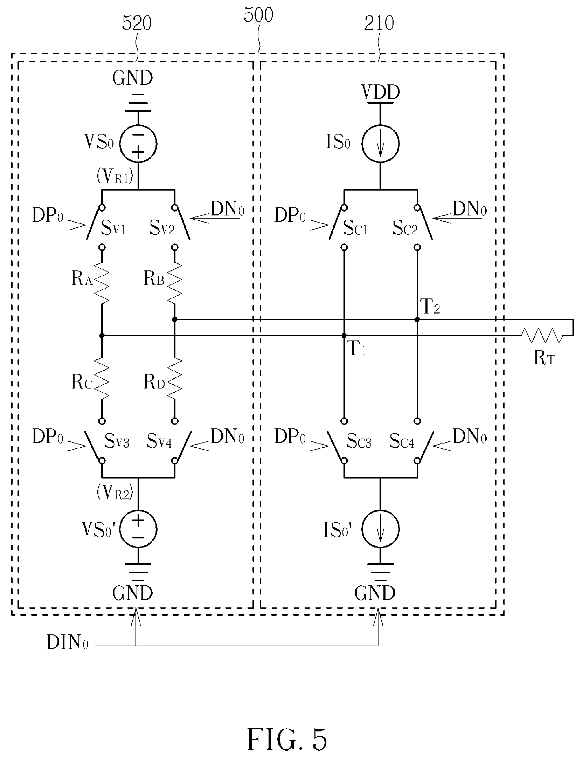

The aforementioned architecture and switch control signals of the voltage mode drive unit 220 are for illustrative purposes, and are not meant to be limitations of the present invention. For example, the switches S_{V1} and S_{V3} (or the switches S_{V2} and S_{V4}) may be replaced by a three-way switch, thus allowing the node N₁ to be coupled to one of the reference voltage V_{R1} and the reference voltage V_{R2} according to the data input DIN₀, and allowing the node N₂ to be coupled to the other of the reference voltage V_{R1} and the reference voltage V_{R2} according to the data input DIN₀. In another example, the voltage sources VS_{A} and VS_{B} may be implemented by a single voltage source, and/or the voltage sources VS_{C} and VS_{D} may be implemented by a single voltage source. Further, the reference voltage V_{R1} and the reference voltage V_{R2} may be coupled to the corresponding output terminals through other circuit topologies. Please refer to FIG. 5, which is a diagram illustrating a second implementation of the driver circuit 100 shown in FIG. 1. The architecture of the driver circuit 500 is based on that of the driver circuit 200 shown in FIG. 2, wherein the main difference is the circuit topology of the voltage mode drive unit. The driver circuit 500 may include the output terminals T₁ and T₂ shown in FIG. 1, the current mode drive unit 210 shown in FIG.2, and a voltage mode drive unit 520. The voltage mode drive unit 520 may be used to implement the voltage mode drive unit 120 shown in FIG. 1.

The voltage mode drive unit 520 may include the switches S_{V1}-S_{V4} shown in FIG. 2, a plurality of voltage sources VS₀ and VS₀', and a plurality of impedance elements (implemented by a plurality of resistors R_{A}-R_{D} in this implementation). The voltage sources VS₀ and VS₀' may generate the reference voltages V_{R1} and V_{R2} shown in FIG. 1, respectively. The resistor R_{A} is coupled between a node N_{A} and the output terminal T₁, and the resistor R_{B} is coupled between a node N_{B} and the output terminal T₂, wherein the reference voltage V_{R1} (the voltage source VS₀) may be coupled to the node N_{A} through the switch S_{V1} or coupled to the node N_{B} through the switch S_{V2} according to the data input DIN₀. The resistor R_{C} is coupled between a node N_{C} and the output terminal T₁, and the resistor R_{D} is coupled between a node N_{D} and the output terminal T₂, wherein the reference voltage V_{R2} (the voltage source VS₀') may be coupled to the node N_{C} through the switch S_{V3} or coupled to the node N_{D} through the switch S_{V4} according to the data input DIN₀. In other words, the switch S_{V1} may be selectively coupled between the reference voltage V_{R1} and the output terminal T₁ (through the resistor R_{A}), the switch S_{V2} may be selectively coupled between the reference voltage V_{R1} and the output terminal T₂ (through the resistor R_{B}), the switch S_{V3} may be selectively coupled between the reference voltage V_{R2} and the output terminal T₁ (through the resistor R_{C}), and the switch S_{V4} may be selectively coupled between the reference voltage V_{R2} and the output terminal T₂ (through the resistor R_{D}).

In this implementation, when the switch S_{V1} and the switch S_{V4} are switched on due to the data input DIN₀, the switch S_{V2} and the switch S_{V3} are switched off; and when the switch S_{V1} and the switch S_{V4} are switched off due to the data input DIN₀, the switch S_{V2} and the switch S_{V3} are switched on. For example, the data signal DP₀ may control switch states of the switches S_{V1} and S_{V3}, wherein when one of the switches S_{V1} and S_{V3} is switched on, the other of the switches S_{V1} and S_{V3} is switched off. Additionally, the data signal DN₀ may control switch states of the switches S_{V2} and S_{V4}, wherein when one of the switches S_{V2} and S_{V4} is switched on, the other of the switches S_{V2} and S_{V4} is switched off. Further, when the switch S_{V1} is switched on due to the data signal DP₀, the switch S_{V2} is switched off due to the data signal DN₀, and when the switch S_{V1} is switched off due to the data signal DP₀, the switch S_{V2} is switched on due to the data signal DN₀.

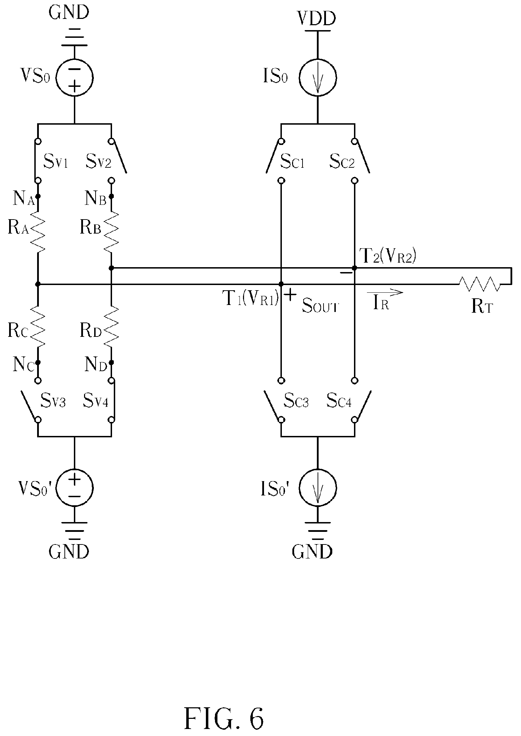

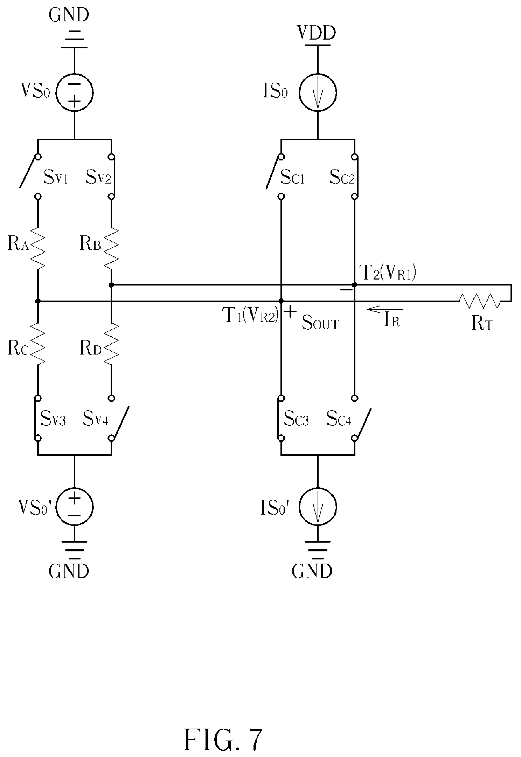

Based on the aforementioned switch operations, when the reference voltage V_{R1} is coupled to one terminal of the resistor R_{A} (the node N_{A}), the reference voltage V_{R2} is coupled to one terminal of the resistor R_{D} (the node N_{D}). In addition, when the reference voltage V_{R1} is coupled to one terminal of the resistor R_{B} (the node N_{B}), the reference voltage V_{R2} is coupled to one terminal of the resistor R_{C} (the node N_{C}). Please refer to FIG. 6 and FIG. 7. FIG. 6 is a diagram illustrating an exemplary output operation of the driver circuit 500 shown in FIG. 5, and FIG. 7 is a diagram illustrating another exemplary output operation of the driver circuit 500 shown in FIG. 5. As switch operations shown in FIG. 6 is similar to those shown in FIG. 3, and switch operations shown in FIG. 7 is similar to those shown in FIG. 4, similar descriptions are not repeated here for brevity. Please note that, if a voltage difference between respective voltages provided by the voltage sources VS₀ and VS₀' is equal to a voltage drop across the termination resistor R_{T} due to the reference current I_{R} flowing therethrough, no current flows through the resistors R_{A} and R_{D} (or the resistors R_{B} and R_{C}). In other words, the voltage mode drive unit 520 shown in FIG. 5 may provide electric potentials for the output terminals T₁ and T₂ without causing a power loss. Further, as the output terminals T₁ and T₂ are a pair of differential output terminals, the resistors R_{A} and R_{D} (or the resistors R_{B} and R_{C}) may have the same impedance value to improve the quality of differential output signals.

The aforementioned architecture and switch control signals of the voltage mode drive unit 520 are for illustrative purposes, and are not meant to be limitations of the present invention. For example, the switches S_{V1} and S_{V2} (or the switches S_{V3} and S_{V4}) may be replaced by a three-way switch, thus allowing the reference voltage V_{R1} to be coupled to one of the node N_{A} and the node N_{B} according to the data input DIN₀, and allowing the reference voltage V_{R2} to be coupled to one of the node N_{C} and the node N_{D} according to the data input DIN₀. Further, the reference voltage V_{R1} and the reference voltage V_{R2} may be directly/indirectly coupled to the corresponding output terminals through other circuit topologies. In brief, as long as a voltage mode drive unit (e.g. the voltage mode drive unit 220/520) may couple the reference voltage V_{R1} to one of the output terminal T₁ and the output terminal T₂ and couple the reference voltage V_{R2} to the other of the output terminal T₁ and the output terminal T₂ according to the data input DIN₀, other variations and modifications fall within the spirit and scope of the present invention.

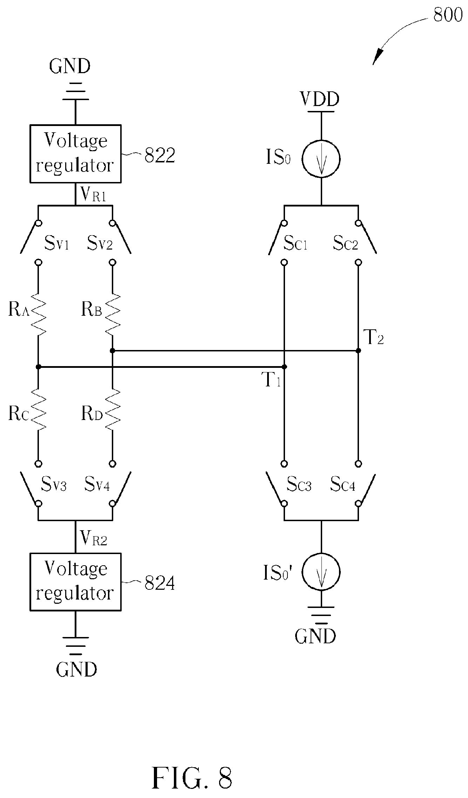

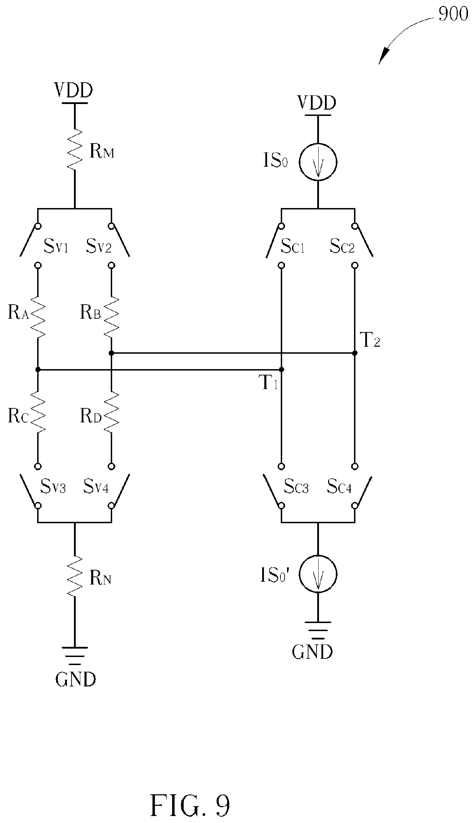

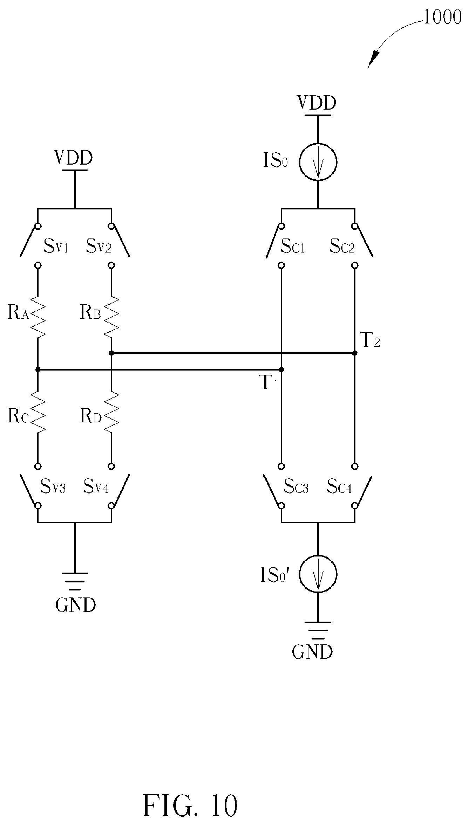

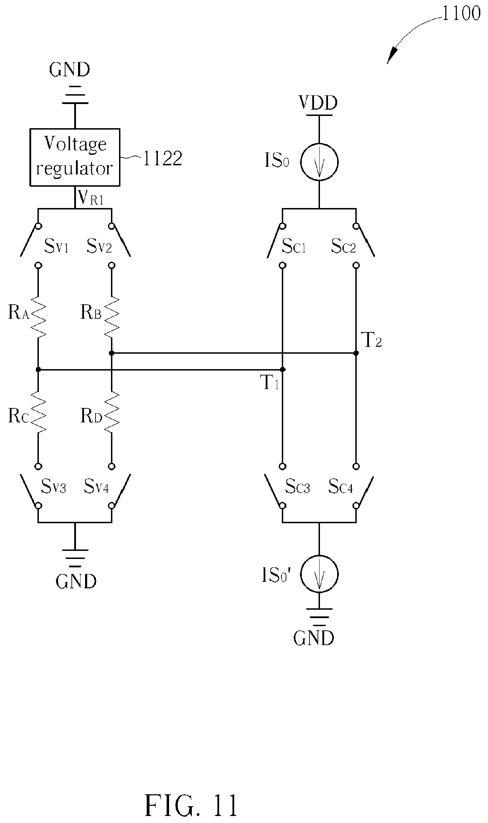

Please note that the voltage source VS₀ and/or the voltage source VS₀' shown in FIG. 5 may be implemented by other voltage generation architectures. For example, as mentioned above, at least one the reference voltage V_{R1} and the reference voltage V_{R2} may be generated by a voltage generation circuit within the proposed driver circuit. In another example, at least one the reference voltage V_{R1} and the reference voltage V_{R2} may be generated by a voltage generation circuit externally coupled to the proposed driver circuit. Please refer to FIGS. 8-12. FIG. 8 is a first alternative design of the driver circuit 500 shown in FIG. 5, wherein the driver circuit 800 employs a voltage regulator 822 and a voltage regulator 824 to generate the reference voltage V_{R1} and the reference voltage V_{R2}, respectively. FIG. 9 is a second alternative design of the driver circuit 500 shown in FIG. 5, wherein the driver circuit 900 employs a resistor R_{M} and a resistor R_{N} to replace the voltage source VS₀ and the voltage source VS₀', respectively. The resistor R_{M} is coupled to the DC power VDD. Hence, the driver circuit 900 uses the DC power VDD and a ground voltage as the reference voltage V_{R1} and the reference voltage V_{R2}, respectively. FIG. 10 is a third alternative design of the driver circuit 500 shown in FIG. 5, wherein the driver circuit 1000 may directly couple the switches S_{V1} and S_{V2} to the DC power VDD, and directly couple the switches S_{V3} and S_{V4} to the reference voltage node GND. Specifically, the driver circuit 1000 may couple an external voltage source/terminal to an output terminal to thereby provide a corresponding reference voltage (e.g. the DC power VDD or the ground voltage). FIG. 11 is a fourth alternative design of the driver circuit 500 shown in FIG. 5, wherein the driver circuit 1100 employs a voltage regulator 1122 to replace the voltage source VS₀ shown in FIG. 5, and directly couple the switches S_{V3} and S_{V4} to the reference voltage node GND. Specifically, the driver circuit 1100 employs the voltage regulator 1122 to generate the reference voltage V_{R1}, and uses a ground voltage as the reference voltage V_{R2} shown in FIG. 5.

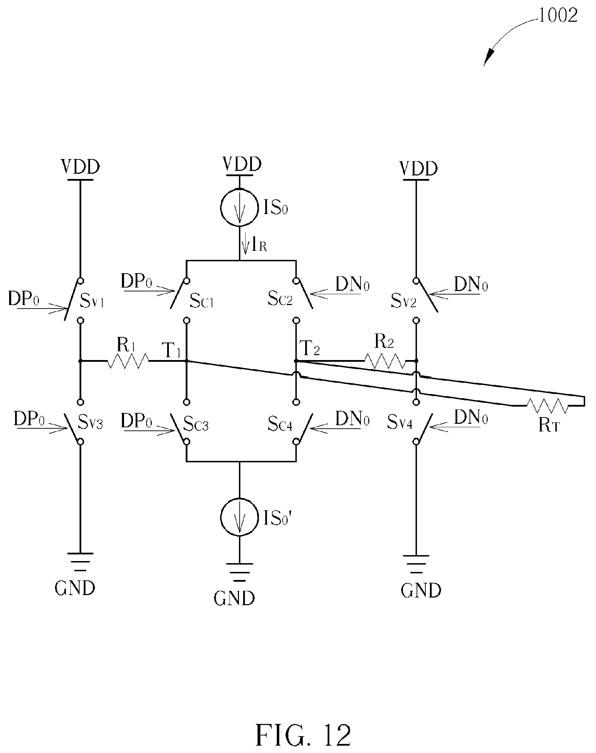

Additionally, the voltage source VS_{A}/VS_{B} used for providing the reference voltage V_{R1} shown in FIG. 2 may be implemented by other voltage generation architectures (e.g. the voltage generation architectures shown in FIGS. 8-11), and/or the voltage source VS_{C}/VS_{D} used for providing the reference voltage V_{R2} shown in FIG. 2 may be implemented by other voltage generation architectures (e.g. the voltage generation architectures shown in FIGS. 8-11). For example, as shown in FIG. 12, the driver circuit 1002 may directly couple the switches S_{V1} and S_{V2} to the DC power VDD to provide a reference voltage, and directly couple the switches S_{V3} and S_{V4} to the reference voltage node GND to provide another reference voltage. As a person skilled in the art should understand the operations of the driver circuit 800/900/1000/1100/1200 after reading above paragraphs directed to FIGS. 1-7, similar description is not repeated here for brevity.

Moreover, the aforementioned voltages supplied to the current mode drive unit and the voltage mode drive unit are not meant to be limitations of the present invention. In an alternative design, it is possible to use a supply voltage different from the DC power VDD for the current mode drive unit and/or the voltage mode drive unit. In another alternative design, a voltage supplied to the current mode drive unit may be different from a voltage supplied to the voltage mode drive unit.

In view of above, the proposed voltage mode drive unit may switch the output terminals T₁ and T₂ (or two terminals of the termination resistor R_{T}) to corresponding voltage sources according to a data logic to be outputted, respectively, and the proposed current mode drive unit may selectively output the reference current to the output terminal T₁/T₂ (or one terminal of the termination resistor R_{T}) according to the data logic to be outputted, thus avoiding/reducing unnecessary power consumption. In addition to avoiding/reducing power consumption, the proposed driver control scheme may increase an output swing of a driver circuit. Further, the proposed driver control scheme described above may be employed in not only a differential driver structure but also a single-ended driver structure. Further description is provided below.

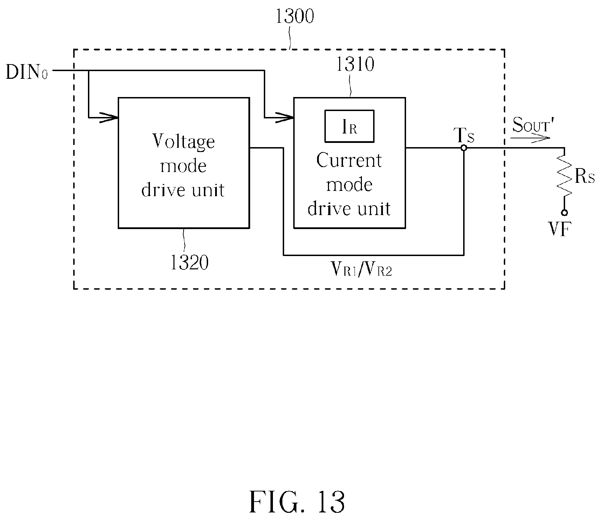

Please refer to FIG. 13, which is a block diagram illustrating an exemplary driver circuit according to another embodiment of the present invention. The architecture of the driver circuit 1300 is based on the architecture of the driver 100 shown in FIG. 1, wherein the main difference is that the driver circuit 1300 employs a single-ended structure. In this embodiment, the driver circuit 1300 may receive the data input DIN₀ and generate an output signal S_{OUT}' to a termination element (implemented by a termination resistor R_{S} in this embodiment) according to the data input DIN₀. By way of example but not limitation, the driver circuit 100 may be employed in a transmitter (not shown in FIG. 1), and the termination resistor R_{S} (or a load resistor) may be located in a receiver (not shown in FIG. 1) and coupled to a reference voltage VF. The driver circuit 1300 may include an output terminals T_{S}, a current mode drive unit 1310 and a voltage mode drive unit 1320. The output signal S_{OUT}' may be regarded as a voltage at the output terminal T_{S}, and correspond to an output data logic (e.g. a logic "1" corresponding to a high voltage or a logic "0" corresponding to a low voltage).

The voltage mode drive unit 1320 is coupled to the output terminal T_{S}, and is arranged for coupling one of the reference voltage V_{R1} and the reference voltage V_{R2} (different from the reference voltage V_{R1}) to the output terminal T_{S} according to the data input DIN₀. Specifically, one of the reference voltage V_{R1} and the reference voltage V_{R2} may be provided for the output terminal T_{S}, so that the output terminal T_{S} may have different electric potentials to provide corresponding output data logics required by the receiver.

The current mode drive unit 1310 is coupled to the output terminal T_{S}, and is arranged for generating the reference current I_{R}, wherein the current mode drive unit 1310 may selectively output the reference current I_{R} from the output terminal T_{S} to the termination resistor R_{S} according to the data input DIN₀. Specifically, when the current mode drive unit 1310 outputs the reference current I_{R}, the current mode drive unit 1310 may steer the reference current I_{R} to flow into the termination resistor R_{S} such that the reference current I_{R} outputted from the current mode drive unit 1310 flows through the termination resistor R_{S} and is used as at least a portion of a current flowing through the termination resistor R_{S}.

Please note that, in a conventional transmitter design of non-return-to-zero (NRZ) or multi-level (e.g. PAM-4) applications, a maximum single-ended output level is limited to one half a supply voltage level. By utilizing the current mode drive unit 1310 capable of selectively outputting the reference current I_{R}, the driver circuit 1300 may increase an electric potential of the output terminal T_{S} (e.g. greater than one half a supply voltage level), thereby increasing an output swing while maintaining a low supply voltage level.

In addition, the current mode drive unit 1310 may selectively receive the reference current I_{R} through the output terminal T_{S} according to the data input DIN₀. For example, in a case where the reference voltage V_{R1} is greater than the reference voltage V_{R2}, when the voltage mode drive unit 1320 couples the reference voltage V_{R1} to the output terminal T_{S} according to the data input DIN₀, the current mode drive unit 1310 may output the reference current I_{R} from the output terminal T_{S} according to the data input DIN₀. Hence, a voltage of the output terminal T_{S} is increased due to the reference current I_{R} flowing through the termination resistor R_{S}. The output signal S_{OUT}' may correspond to a specific output data logic (e.g. a logic "1"). Additionally, when the voltage mode drive unit 1320 couples the reference voltage V_{R2} to the output terminal T_{S} according to the data input DIN₀, the current mode drive unit 1310 may receive the reference current I_{R} through the output terminal T_{S} according to the data input DIN₀. The voltage of the output terminal T_{S} may be decreased due to the reference current I_{R} flowing into the current mode drive unit 1310. The output signal S_{OUT}' may correspond to another specific output data logic (e.g. a logic "0"). Since a voltage level corresponding to the specific output data logic is increased (and/or decreased) due to a voltage drop across the termination resistor R_{S}, a high output swing can be obtained without the need for a high supply voltage.

Additionally, as the voltage mode drive unit 1320 may couple one of the reference voltage V_{R1} and the reference voltage V_{R2} according to the data input DIN₀, and the current mode drive unit 1310 may selectively output/receive the reference current I_{R} from the output terminal T_{S} according to the data input DIN₀, one skilled in the art should understand the driver control mechanism employed in the driver circuit 100 shown in FIG. 1 may be applied to the driver circuit 1300, wherein the driver circuit 100 may be regarded as, but is not limited to, a driver circuit employing bridge termination, and the driver circuit 1300 may be regarded as, but is not limited to, a driver circuit employing single-ended termination. Hence, the control mechanism described in above paragraphs directed to FIGS. 1-12 may be applied to a proposed driver circuit having a single-ended structure.

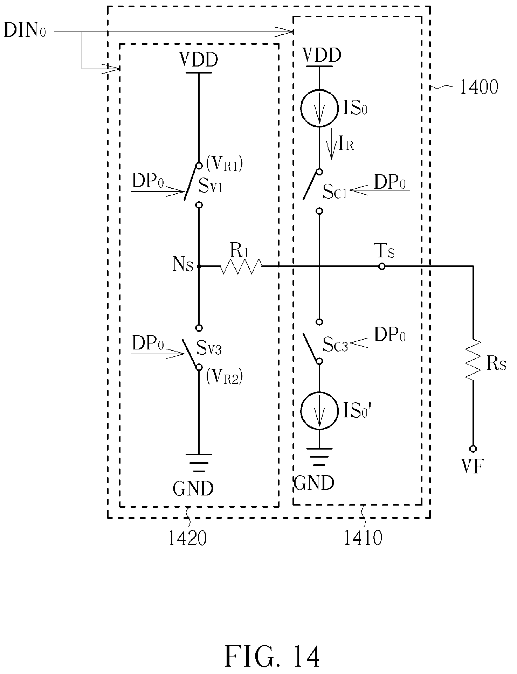

FIG. 14 is a diagram illustrating an implementation of the driver circuit 1300 shown in FIG. 13. In this implementation, the driver circuit 1400 may include the output terminal T_{S} shown in FIG. 13, a current mode drive unit 1410 and a voltage mode drive unit 1420, wherein the current mode drive unit 1310 and the voltage mode drive unit 1320 shown in FIG. 13 may be implemented by the current mode drive unit 1410 and the voltage mode drive unit 1420, respectively. Additionally, the symbol VDD denotes a direct current (DC) power required by circuit elements, and the symbol GND denotes a reference voltage node (e.g. a common ground).

The current mode drive unit 1410 may include the current source IS₀ and the current sink IS₀' shown in FIG. 2. The current source IS₀ may be arranged for generating the reference current I_{R}, and is selectively coupled to the output terminal T_{S} according to the data input DIN₀. The current sink IS₀' may be arranged for receiving the reference current I_{R}, and is selectively coupled to the output terminal T_{S} according to the data input DIN₀, wherein when one of the current source IS₀ and the current sink IS₀' is coupled to the output terminal T_{S} according to the data input DIN₀, the other of the current source IS₀ and the current sink IS₀' is not coupled to the output terminal T_{S}.

In this implementation, the current mode drive unit 1610 may include further include the switches S_{C1} and S_{C3}, wherein switch states of the switches S_{C1} and S_{C2} are controlled by the data signal DP₀ of the data input DIN₀. The switch S_{C1} is selectively coupled between the current source IS₀ and the output terminal T_{S} according to the data signal DP₀, and the switch S_{C2} is selectively coupled between the current sink IS₀' and the output terminal T_{S} according to the data signal DP₀, wherein when the switch S_{C1} is switched on due to the data signal DP₀, the switch S_{C2} is switched off; and when the switch S_{C1} is switched off due to the data signal DP₀, the switch S_{C2} is switched on. Specifically, the switching operations of the switches S_{C1} and S_{C3} in this embodiment are identical/similar to those of the switches S_{C1} and S_{C3} shown in FIG. 2.

The voltage mode drive unit 1420 may include the impedance element (implemented by the resistor R₁) and the switches S_{V1} and S_{V3} shown in FIG. 2. The resistor R₁ is coupled between a node N_{S} and the output terminal T_{S}, wherein the node N_{S} may be coupled to the DC power VDD (i.e. the reference voltage V_{R1}) through the switch S_{V1} or coupled to a ground voltage (i.e. the reference voltage V_{R2}) through the switch S_{V3} according to the data input DIN₀. To put it differently, the switch S_{V1} is selectively coupled between the reference voltage V_{R1} and the output terminal T_{S} (through the resistor R₁) according to the data input DIN₀, and the switch S_{V3} is selectively coupled between the reference voltage V_{R2} and the output terminal T_{S} (through the resistor R₁) according to the data input DIN₀.

In this implementation, when the switch S_{V1} is switched on due to the data input DIN₀, the switch S_{V3} is switched off; when the switch S_{V1} is switched off due to the data input DIN₀, the switch S_{V3} is switched on. For example, the data signal DP₀ of the data input DIN₀ may control switch states of the switches S_{V1} and S_{V3}, wherein when one of the switches S_{V1} and S_{V3} is switched on, the other of the switches S_{V1} and S_{V3} is switched off. Based on the aforementioned switch operations, one terminal of the resistor R₁ is coupled to output terminal T_{S}, and another terminal of the resistor R₁ (the node N_{S}) may be coupled to the DC power VDD through the switch S_{V1} or coupled to the ground voltage through the switch S_{V3} according to the data input DIN₀.

For example, in a case where the reference voltage V_{R1} is greater than the reference voltage V_{R2}, when the switch S_{V1} is switched on according to the data signal DP₀ such that the reference voltage V_{R1} (the DC power VDD) is coupled to the output terminal T_{S} through the resistor R₁, the switch S_{C1} is switched on, and the switches S_{V3} and S_{C3} are switched off. Hence, the reference current I_{R} generated from the current source IS₀ may be outputted from the output terminal T_{S} to the termination resistor R_{S} through the switch S_{C1}, thus increasing a voltage of the output terminal T_{S}. Additionally, when the switch S_{V1} is switched off and the switch S_{V3} is switched on, the switch S_{C1} is switched off and the switch S_{C3} is switched on such that the current sink IS₀' receives the reference current I_{R}. Based on the above switching operations, a high output swing can be obtained without the use of a high supply voltage.

The aforementioned architecture and switch control signal of the voltage mode drive unit 1420 are for illustrative purposes, and are not meant to be limitations of the present invention. In one alternative design, the switches S_{V1} and S_{V3} may be replaced by a three-way switch, thus allowing the node N_{S} to be coupled to one of the DC power VDD and the ground voltage according to the data input DIN₀.

In another alternative design, the switches S_{V1} and S_{V3} and the resistor R₁ shown in FIG. 14 may be replaced by the switches S_{V1} and S_{V3} and the resistors R_{A} and R_{C} shown in FIG. 5. In other words, the structure of the voltage mode drive unit 1420 may be modified by the voltage mode drive unit 520 shown in FIG. 5 in this alternative design. Hence, one terminal of the resistor R_{A} is coupled to an output terminal (i.e. the output terminal T_{S}), and another terminal of the resistor R_{A} is selectively coupled to the DC power VDD through the switch S_{V1} according to the data input DIN₀; one terminal of the resistor R_{B} is coupled to the output terminal (i.e. the output terminal T_{S}), and another terminal of the resistor R_{B} is selectively coupled to the ground voltage through the switch S_{V1} according to the data input DIN₀. As one skilled in the art can understand that the operation of the voltage mode drive unit 1420 modified by the voltage mode drive unit 520 shown in FIG. 5, further description is omitted here for brevity.

In yet another alternative design, the switches S_{V1} and S_{V3} and the resistor R₁ shown in FIG. 14 may be replaced by the resistors R_{A} and R_{C} shown in FIG. 5 and a three-way switch (not shown in FIG. 14). Hence, when the DC power VDD is coupled to the output terminal T_{S} through the resistor R_{A} according to the data input DIN₀, the ground voltage is not coupled to the output terminal T_{S}; when the ground voltage is coupled to the output terminal T_{S} through the resistor R_{B} according to the data input DIN₀, the DC power VDD is not coupled to the output terminal T_{S}.

In still another alternative design, the switches S_{C1} and S_{C3} may be replaced by a three-way switch, thus allowing the output terminal T_{S} to be coupled to one of the current source IS₀ and the current sink IS₀' according to the data input DIN₀.

In brief, as long as the node N_{S} may be coupled to one of the DC power VDD and the ground voltage according to the data input DIN₀, and one of the current source IS₀ and the current sink IS₀' may be coupled to the output terminal T_{S} according to the data input DIN₀, such alternatives and modifications fall within the scope of the present invention.

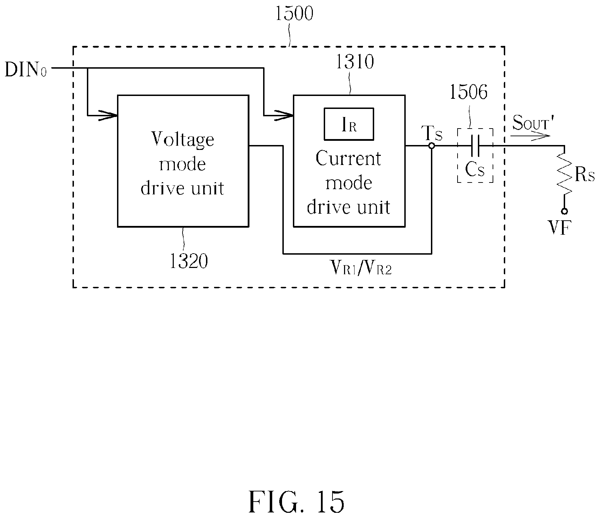

In one embodiment, the proposed driver circuit may further use coupling techniques to adjust a voltage level at an output terminal. Please refer to FIG. 15, which is a block diagram illustrating an exemplary driver circuit according to another embodiment of the present invention. The architecture of the driver circuit 1500 is based on the architecture of the driver 1300 shown in FIG. 13, wherein the main difference is that the driver circuit 1500 utilizes a capacitive element 1506 (implemented by a capacitor C_{S} in this embodiment) to adjust a voltage level at the output terminal T_{S}. For example, when the termination resistor R_{S} is coupled to a ground terminal (the reference voltage VF is implemented by a ground voltage), coupling the capacitor C_{S} between the output terminal T_{S} and the termination resistor R_{S} may prevent the voltage level at the output terminal T_{S} from falling below zero volts.

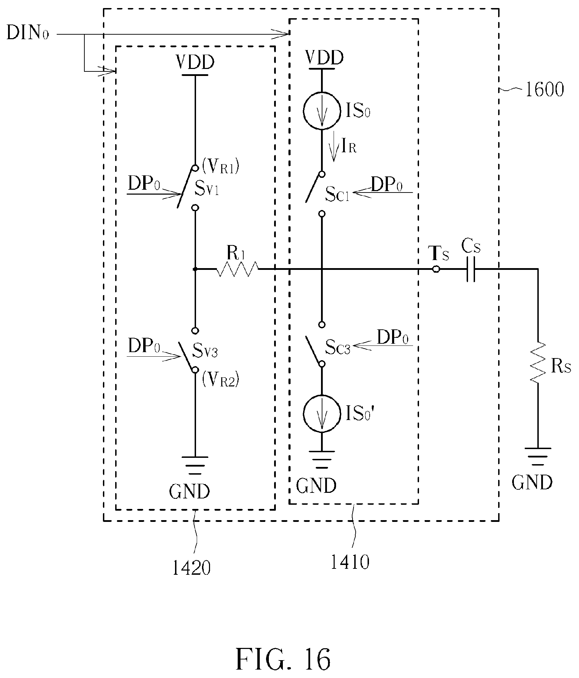

FIG. 16 is a diagram illustrating an implementation of the driver circuit 1500 shown in FIG. 15. The architecture of the driver circuit 1600 is based on the architecture of the driver 1400 shown in FIG. 14, wherein the main difference is that the driver circuit 1600 uses the capacitor C_{S} for AC coupling. In this implementation, the termination resistor R_{S} is coupled to the common ground GND for illustrative purposes. One skilled in the art should understand that this is not meant to be a limitation of the present invention. By way of example but not limitation, assuming that a magnitude of the DC power VDD is 1 V, a magnitude of the reference current I_{R} is 1 mA, and each of an impedance value of the resistor R₁ and an impedance value of the termination resistor R_{S} equals to 50 ohm (impedance matching), a maximum voltage level at the output terminal T_{S} may be increased to 775 mV (i.e. VDD/2 + VDD/4+ I_{R}xR_{S}/2), and a minimum voltage level at the output terminal T_{S} may be 225 mV (i.e. VDD/2 - VDD/4 - I_{R}xR_{S}/2). The output voltage swing of the output terminal T_{S} may be represented by (VDD/2 + I_{R}xR_{S}). As a person skilled in the coupling techniques should understand the operations of the driver circuit 1500/1600 after reading the paragraphs directed to FIGS. 1-14, further description is omitted here for brevity.

A driver circuit having a differential pair of output terminals may utilize the proposed driver control mechanism to increase the output swing. Please refer to FIG. 12 again. In a case where the DC power VDD (one reference voltage) is greater than the ground voltage (another reference voltage), when the switches S_{V1} and S_{C1} are switched on according to the data signal DP₀, the switches S_{V4} and S_{C4} are switched on according to the data signal DN₀, the switches S_{V3} and S_{C3} are switched off according to the data signal DP₀ and the switches S_{V2} and S_{C2} are switched off according to the data signal DN₀. Additionally, when the switches S_{V1} and S_{C1} are switched off according to the data signal DP₀, the switches S_{V4} and S_{C4} are switched off according to the data signal DN₀, the switches S_{V3} and S_{C3} are switched on according to the data signal DP₀ and the switches S_{V2} and S_{C2} are switched on according to the data signal DN₀. By way of example but not limitation, assuming that a magnitude of the DC power VDD is 1 V, a magnitude of the reference current I_{R} is 1 mA, each of an impedance value of the resistors R₁ and R₂ equals to 50 ohm, and an impedance value of the termination resistor R_{T} equals to 100 ohm (impedance matching), a maximum voltage level at the output terminal T_{S} may be increased to 550 mV (i.e. VDD/2 + I_{R}xR_{T}/2), and a minimum voltage level at the output terminal T_{S} may be -550 mV (i.e. -VDD/2 - I_{R}xR_{S}/2). The output voltage swing of the output terminal T_{S} may be represented by (VDD + I_{R}xR_{S}).

In view of the above, compared to a conventional transmitter design having a maximum differential output level (a peak-to-peak level) limited to a supply voltage level, the proposed driver circuit may obtain an output swing higher than the supply voltage level (i.e. VDD).

In one embodiment, the proposed driver control mechanism may be employed in other differential circuit topologies, such as the driver circuit 500 shown in FIG. 5, to increase an output swing. As a person skilled in the art should understand the operations of a differential driver circuit utilizing the proposed driver control mechanism after reading above paragraphs directed to FIGS. 1-16, further description is omitted here for brevity.

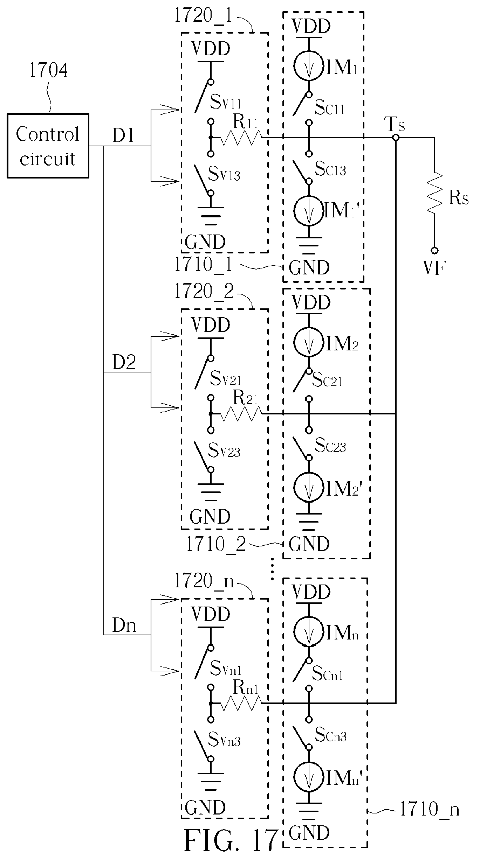

The proposed driver control mechanism may be employed in a multi-level driver. Please refer to FIG. 17, which is a diagram illustrating an exemplary driver circuit according to an embodiment of the present invention. The architecture of the driver circuit shown in FIG. 17 is based on that of the driver circuit 1400 shown in FIG. 14, and the main difference is that the driver circuit shown in FIG. 17 includes n current mode drive units 1710_1-1710_n and n voltage mode drive units 1720_1-1720_n, wherein n is an integer greater than one. The driver circuit shown in FIG. 17 generates an output signal to the termination resistor R_{S} according to n data inputs (having data signals D1-Dn respectively) generated from a control circuit 1704, which may be implemented by a digital-to-analog converter (DAC), a transmit finite impulse response (FIR) circuit or other types of control circuit. In this embodiment, the current mode drive unit 1710_1 and the voltage mode drive unit 1720_1 are controlled by the data signal D1, the current mode drive unit 1710_2 and the voltage mode drive unit 1720_2 are controlled by the data signal D2, and so on.

Each current mode drive unit includes a current source (one of current sources IM₁-IMₙ), a current sink (one of current sinks IM₁'-IMₙ') and a set of switches (e.g. switches S_{C11}-S_{C13}/S_{C21}-S_{C23}/.../S_{Cn1}-S_{Cn3}), and may output a reference current from the output terminal T_{S} to the termination resistor R_{S} according to a corresponding data input (one of the data signals D1-Dn). Each voltage mode drive unit includes a set of switches (e.g. switches S_{V11}-S_{V13}/S_{V21}-S_{V23}/.../S_{Vn1}-S_{Vn3}) and an impedance element (one of resistors R₁₁-Rₙ₁), and may couple one of the DC power VDD and the ground voltage to the output terminal T_{S} according to a corresponding data input (one of the data signals D1-Dn).

In one exemplary design where the control circuit 1704 is implemented by a DAC providing a binary-weighted output code, the n data inputs (the data signals D1-Dn) correspond to a binary code of n bits, and the generated output signal (e.g. the voltage level at the output terminal T_{S}) may include n components which are generated in response to the data signals D1-Dn respectively. In other words, the n components of the generated output signal have a binary-weighted relationship.

In another exemplary design where the control circuit 1704 is implemented by a transmit FIR circuit, different voltage/current mode drive units are used for pre-emphasis and/or de-emphasis, wherein one of the data signals D1-Dn is an advanced signal or a delayed signal relative to another/others of the data signals D1-Dn. As a person skilled in the multi-level driver circuitry should understand the operations of the driver circuit shown in FIG. 17 after reading the paragraphs directed to FIGS. 1-14, further description is omitted for brevity.

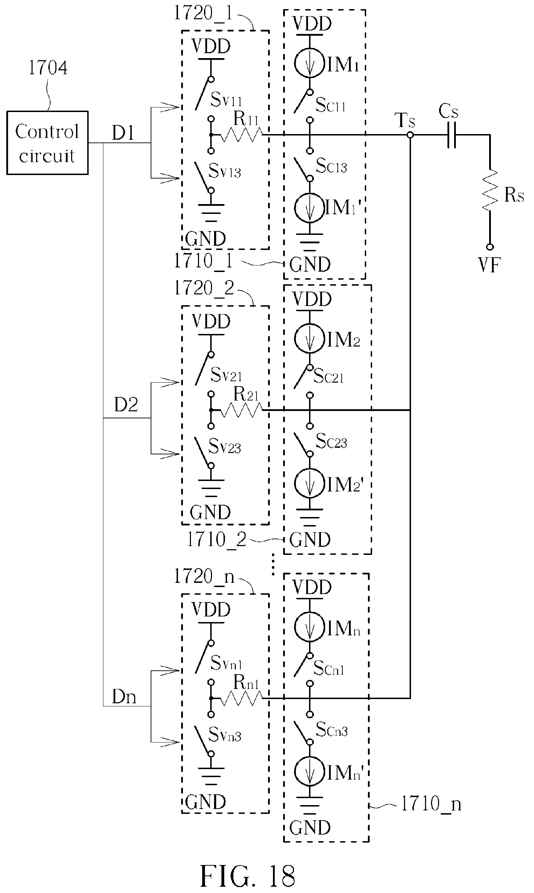

FIG. 18 is a diagram illustrating an exemplary driver circuit according to another embodiment of the present invention. The architecture of the driver circuit shown in FIG. 18 is based on that of the driver circuit shown in FIG. 17, and the main difference is that the driver circuit shown in FIG. 18 further includes the capacitor C_{S} for AC coupling. After reading the paragraphs directed to FIGS. 1-17, a person skilled in the art should understand that the operations of the driver circuit shown in FIG. 18 employed in the multi-level driver applications. Similar description is not repeated here for brevity.

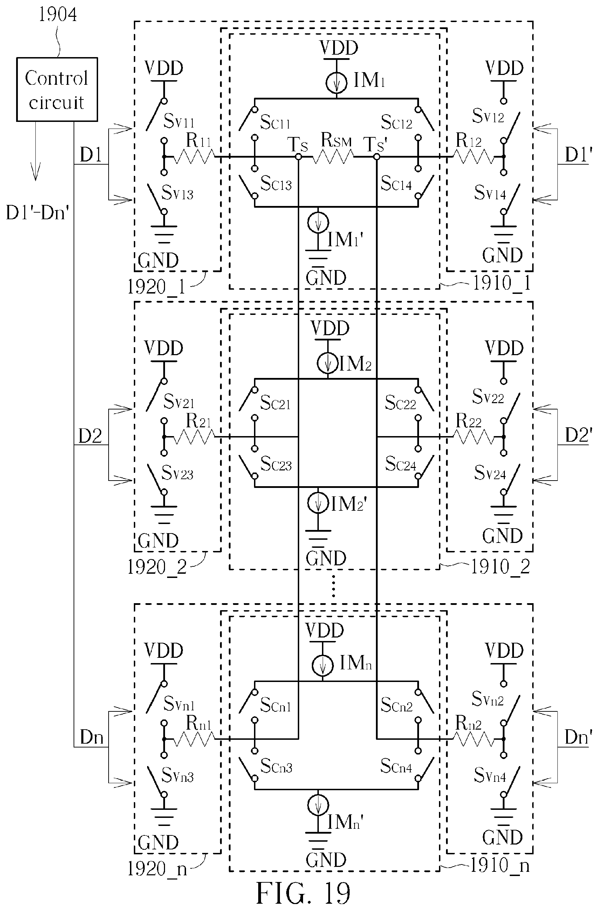

FIG. 19 is a diagram illustrating an exemplary driver circuit according to another embodiment of the present invention. The architecture of the driver circuit shown in FIG. 19 is based on that of the driver circuit 1200 shown in FIG. 12, and the main difference is that the driver circuit shown in FIG. 19 includes n current mode drive units1910_1-1910_n and n voltage mode drive units 1920_1-1920_n, wherein n is an integer greater than one. The driver circuit shown in FIG. 19 generates an output signal to the termination resistor R_{S} according to n data inputs generated from a control circuit 1904, which may be implemented by a digital-to-analog converter (DAC), a transmit finite impulse response (FIR) circuit or other types of control circuit. In this embodiment, each of the n data inputs includes a first data signal (one of the data signals D1-Dn) and a second data signal (one of the data signals D1'-Dn'), wherein the first data signal and the second data signal may be inverted with respect to each other, or non-overlapping signals. In addition, the current mode drive unit 1910_1 and the voltage mode drive unit 1920_1 are controlled by the data signal D1 and the data signal D1', the current mode drive unit 1910_2 and the voltage mode drive unit 1920_2 are controlled by the data signal D2 and the data signal D2', and so on.

Each current mode drive unit includes a current source (one of current sources IM₁-IMₙ), a current sink (one of current sinks IM₁'-IMₙ') and a set of switches (e.g. switches S_{C11}-S_{C14}/S_{C21}-S_{C24}/.../S_{Cn1}-S_{Cn4}), and may output/receive a reference current from a differential pair of output terminals (having output terminals T_{S} and T_{S}') according to a corresponding data input (a set of the data signals D1-D1'/D2-D2'/.../Dn-Dn'). Each voltage mode drive unit includes a set of switches (e.g. switches S_{V11}-S_{V14}/S_{V21}-S_{V24}/.../S_{Vn1}-S_{Vn4}) and a set of impedance elements (resistors R₁₁-R₁₂/R₂₁-R₂₂/.../Rₙ₁-Rₙ₂), and may couple the DC power VDD to one of the output terminals T_{S} and T_{S}' and couple the ground voltage to the other of the output terminals T_{S} and T_{S}' according to a corresponding data input (a set of the data signals D1-D1'/D2-D2'/.../Dn-Dn').

In one exemplary design where the control circuit 1904 is implemented by a DAC providing a binary-weighted output code, the n data inputs (i.e. the data signals D1-Dn or D1'-Dn') correspond to a binary code of n bits, and the generated output signal may include n components which are generated in response to the n data inputs respectively. In other words, the n components of the generated output signal have a binary-weighted relationship.

Consider a case where the data signals D1-Dn are generated by a 3-bit DAC (i.e. n equals to 3). By way of example but not limitation, when a magnitude of the DC power VDD is 1 V, a sum of respective magnitudes of reference currents generated from the current sources IM₁-IM₃ is 1 mA, and a sum of respective inverses of impedance values of the resistors R₁₁-Rₙ₁ (i.e. 1/R₁₁+1/R₂₁+...+1/Rₙ₁) equals to an inverse of one half an impedance value of the termination resistor R_{SM}, a sum of respective inverses of impedance values of the resistors R₁₂-Rₙ₂ (i.e. 1/R₁₂+1/R₂₂+...+1/Rₙ₂) equals to the inverse of one half the impedance value of the termination resistor R_{SM}, and the impedance value of the termination resistor R_{SM} equals to 100 ohm, the relationship between the binary-weighted code and a differential output (a level difference between the output terminals T_{S} and T_{S}') is shown in the table below.

| D3/D2/D1 | Differential output |
|---|---|
| 1/1/1 | + 550 mV |
| 1/1/0 | + 393 mV |
| 1/0/1 | + 236 mV |
| 1/0/0 | + 79 mV |
| 0/1/1 | - 79 mV |
| 0/1/0 | - 236 mV |
| 0/0/1 | - 393 mV |
| 0/0/0 | - 550 mV |

In another exemplary design where the control circuit 1904 is implemented by a transmit FIR circuit, different voltage/current mode drive units are used for pre-emphasis and/or de-emphasis, wherein one of the n data inputs is an advanced signal or a delayed signal relative to another/others of the n data inputs.

Consider a case where the data signals D1-Dn are generated by a 3-tap transmit FIR circuit (i.e. n equals to 3) and a weight ratio corresponding to D1-Dn is 5:2:1. By way of example but not limitation, when a magnitude of the DC power VDD is 1 V, a sum of respective magnitudes of reference currents generated from the current sources IM₁-IM₃ is 1 mA, and a sum of respective inverses of impedance values of the resistors R₁₁-Rₙ₁ (i.e. 1/R₁₁+1/R₂₁+...+1/Rₙ₁) equals to an inverse of one half an impedance value of the termination resistor R_{SM}, a sum of respective inverses of impedance values of the resistors R₁₂-Rₙ₂ (i.e. 1/R₁₂+1/R₂₂+...+1/Rₙ₂) equals to the inverse of one half the impedance value of the termination resistor R_{SM}, and the impedance value of the termination resistor R_{SM} equals to 100 ohm, the relationship between the binary-weighted code and a differential output (a level difference between the output terminals T_{S} and T_{S}') is shown in the table below.

| D3/D2/D1 | Differential output |
|---|---|
| 1/1/1 | + 550 mV |
| 1/1/0 | + 413 mV |
| 1/0/1 | + 275 mV |
| 1/0/0 | + 138 mV |
| 0/1/1 | - 138 mV |
| 0/1/0 | - 275 mV |
| 0/0/1 | - 413 mV |
| 0/0/0 | - 550 mV |

As a person skilled in the multi-level driver circuitry should understand the operations of the driver circuit shown in FIG. 19 after reading the paragraphs directed to FIGS. 1-18, further description is omitted here for brevity.

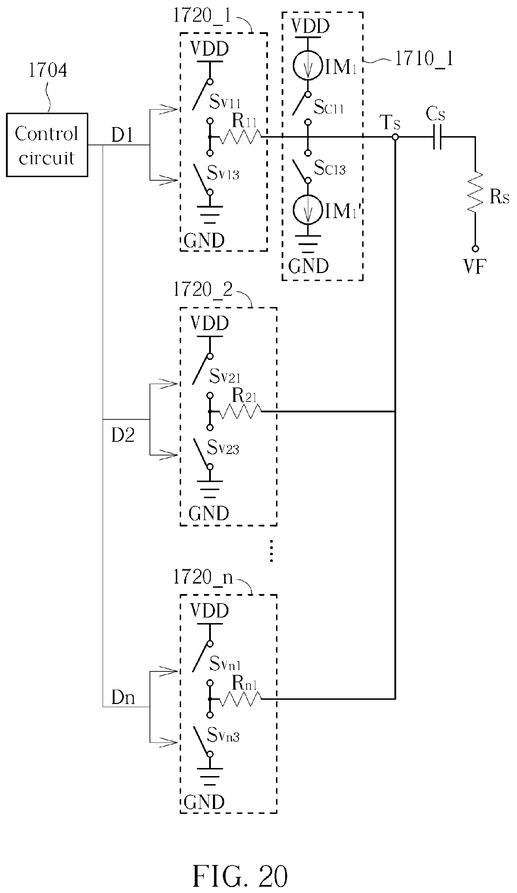

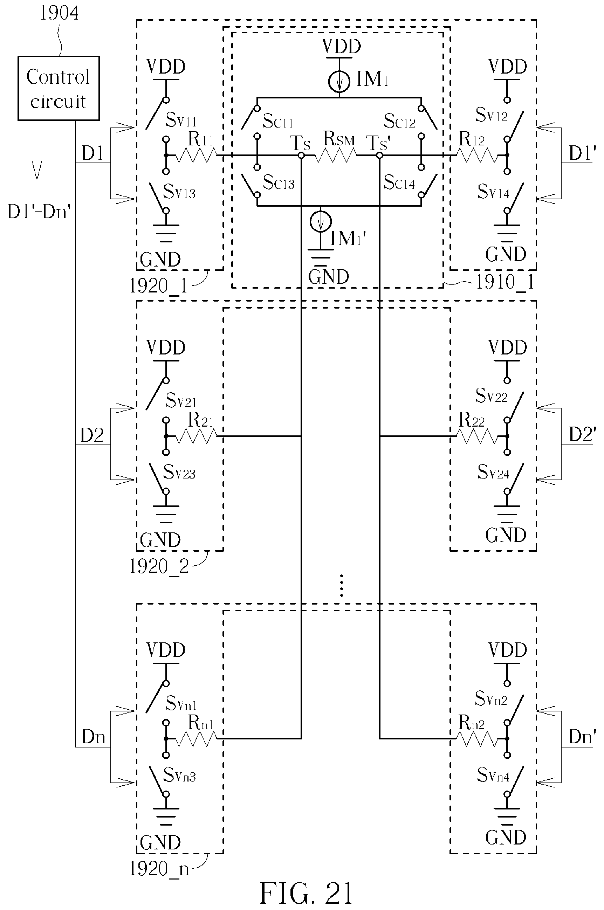

The above is for illustrative purposes only, and is not meant to be a limitation of the present invention. In an alternative design, the number of the current mode drive units and the number of the voltage mode drive units may be different. For example, high speed application may use less current mode drive units to increase bandwidth. FIG. 20 illustrates an example where the number of the current mode drive units may be less than the number of the voltage mode drive units in a single-ended driver structure, and FIG. 21 illustrates an example where the number of the current mode drive units may be less than the number of the voltage mode drive units in a differential driver structure. In another example, it is possible to utilize the proposed drive control mechanism in a driver circuit where number of the voltage mode drive units may be less than the number of the current mode drive units.

Please note that, in a case where the proposed driver circuit is employed in an equalizer architecture in order to improve quality of signal transmission, the proposed current mode drive unit may be utilized to increase design flexibility. An exemplary implementation of a three-tap finite impulse response (FIR) equalizer is given in the following for description of the proposed equalizer architecture. However, a person skilled in the art should understand that this is not meant to be a limitation of the present invention.

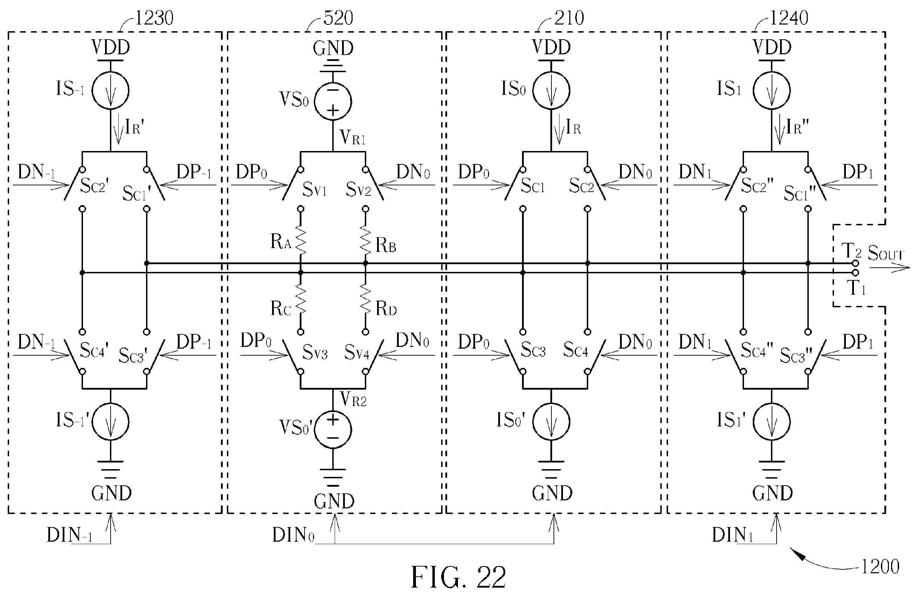

FIG. 22 is a diagram illustrating an exemplary driver circuit according to an embodiment of the present invention. The architecture of the driver circuit 1200 is based on that of the driver circuit 500 shown in FIG. 5, wherein the main difference is that the driver circuit 1200 may further include a current mode drive unit 1230 and a current mode drive unit 1240 for pre-emphasis and/or de-emphasis. Specifically, the driver circuit 1200 may receive a plurality of data inputs DIN₀, DIN₋₁ and DIN₁, and accordingly generate the output signal S_{OUT}, wherein the data input DIN₋₁ is an advanced data input relative to the data input DIN₀, and the data input DIN₁ is a delayed data input relative to the data input DIN₀. The current mode drive unit 1230 is coupled to the output terminal T₁ and the output terminal T₂ (a pair of differential output terminals), and is arranged for generating a reference current I_{R}', outputting the reference current I_{R}' from one of the output terminal T₁ and the output terminal T₂ according to the data input DIN₋₁, and receiving the reference current I_{R}' from the other of the output terminal T₁ and the output terminal T₂ according to the data input DIN₋₁. The current mode drive unit 1240 is coupled to the output terminal T₁ and the output terminal T₂, and is arranged for generating a reference current I_{R}", outputting the reference current I_{R}" from one of the output terminal T₁ and the output terminal T₂ according to the data input DIN₁, and receiving the reference current I_{R}" from the other of the output terminal T₁ and the output terminal T₂ according to the data input DIN₁.

In this embodiment, the architecture of the current mode drive unit 1230 is based on that of the current mode drive unit 210, and the architecture of the current mode drive unit 1240 is based on that of the current mode drive unit 210. Hence, the current mode drive unit 1230 may include a current source IS₋₁, a current sink IS₋₁' and a plurality of switches S_{C1}'-S_{C4}', and the current mode drive unit 1240 may include a current source IS₁, a current sink IS₁' and a plurality of switches S_{C1}"-S_{C4}". The data input DIN₋₁ may include a data signal DP₋₁ and a data signal DN₋₁, wherein the data signal DP₋₁ and the data signal DN₋₁ may be inverted with respect to each other, or non-overlapping signals. The data signal DP₋₁ may control switch states of the switches S_{C1}' and S_{C3}', and the data signal DN₋₁ may control switch states of the switches S₂' and S_{C4}', wherein the data signal DP₋₁ is an advanced signal relative to the data signal DP₀ (e.g. advanced by one bit period), and the data signal DN₋₁ is an advanced signal relative to the data signal DN₀ (e.g. advanced by one bit period). Similarly, the data input DIN₁ may include a data signal DP₁ and a data signal DN₁, wherein the data signal DP₁ and the data signal DN₁ may be inverted with respect to each other, or non-overlapping signals. The data signal DP₁ may control switch states of the switches S_{C1}" and S_{C3}", and the data signal DN₁ may control switch states of the switches S_{C2}" and S_{C4}", wherein the data signal DP₁ is an delayed signal relative to the data signal DP₀ (e.g. delayed by one bit period), and the data signal DN₁ is a delayed signal relative to the data signal DN₀ (e.g. delayed by one bit period).

As the purpose of pre-emphasis/de-emphasis is to apply advance/delay and inversion to a signal and add the signal back to an original signal with a proper weight, the switches S_{C2}' and S_{C4}' coupled to the output terminal T₁ may be controlled by the data signal DN₋₁ (the advanced signal relative to the data signal DN₀), the switches S_{C2}" and S_{C4}" coupled to the output terminal T₁ may be controlled by the data signal DN₁ (the delayed signal relative to the data signal DN₀), the switches S_{C1}' and S_{C3}' coupled to the output terminal T₂ may be controlled by the data signal DP₋₁ (the advanced signal relative to the data signal DP₀), and the switches S_{C1}" and S_{C3}" coupled to the output terminal T₂ may be controlled by the data signal DP₁ (the delayed signal relative to the data signal DP₀). Additionally, respective magnitudes of the reference currents I_{R}' and I_{R}" may be adjusted according to design considerations. As a person skilled in the field of transmitter equalizers should understand the operations of the driver circuit 1200 employed in a three-tap FIR equalizer after reading above paragraphs directed to FIGS. 1 - 7, further description is omitted here for brevity.

As shown in FIG. 22, channel loss compensation may be achieved by merely adding the current mode drive units 1230 and 1240 without modifying original circuit elements (e.g. the current mode drive unit 210 and/or the voltage mode drive unit 520), which means that the proposed driver architecture may have high design flexibility. Specifically, an N-tap FIR equalizer may be easily implemented using the proposed driver architecture, wherein N is a positive integer. For example, the current mode drive unit 1230 or the current mode drive unit 1240 may be optional. In another example, other current mode drive unit(s) may be added to implement an equalizer. Further, the current mode drive unit 210/1230/1240 may be replaced by a current mode drive unit which is implemented based on the operations of the current mode drive unit 110 shown in FIG. 1, and/or the voltage mode drive unit 520 may be replaced by a voltage mode drive unit which is implemented based on the operations of the voltage mode drive unit 120 shown in FIG. 1. For example, the driver circuit 200 shown in FIG. 2 may be used to implement the N-tap FIR equalizer.

To sum up, the proposed driver circuit may not only reduce power loss but also have high design flexibility. Additionally, as the proposed driver circuit may decrease a drive current, a size of a switch device may be reduced, thus decreasing a load impedance seen by a differential output pair and reducing parasitic capacitance. Moreover, the proposed driver circuit may increase an output swing while maintaining a low supply voltage level.

All combinations and sub-combinations of the above-described features also belong to the invention.

## Claims

1. A driver circuit (100, 200, 500, 800, 900, 1000, 1002, 1100, 1200, 1300, 1400, 1500, 1600) for receiving a first data input and generating an output signal to a termination element according to at least the first data input, the driver circuit comprising:
a first output terminal, arranged for outputting the output signal; and
**characterized by**:
a first current mode drive unit (110, 210, 1310, 1410, 1710_1, 1910_1), coupled to the first output terminal, the first current mode drive unit (110, 210, 1310, 1410, 1710_1, 1910_1) arranged for generating a first reference current, selectively outputting the first reference current from the first output terminal to the termination element according to the first data input, and selectively receiving the first reference current through the first output terminal according to the first data input, wherein when the first current mode drive unit (110, 210, 1310, 1410, 1710_1, 1910_1) outputs the first reference current, the first current mode drive unit (110, 210, 1310, 1410, 1710_1, 1910_1) steers the first reference current to flow into the termination element such that the first reference current outputted from the first current mode drive unit (110, 210, 1310, 1410, 1710_1, 1910_1) flows through the termination element and is used as at least a portion of a current flowing through the termination element; and
a first voltage mode drive unit (120, 220, 520, 1320, 1420, 1720_1, 1920_1), coupled to the first output terminal, the first voltage mode drive unit (120, 220, 520, 1320, 1420, 1720_1, 1920_1) arranged for coupling one of a first reference voltage and a second reference voltage to the first output terminal according to the first data input, wherein the first reference voltage is different from the second reference voltage.

2. The driver circuit of claim 1, **characterized in that** the first reference voltage is greater than the second reference voltage; when the first voltage mode drive unit (120, 220, 520, 1320, 1420, 1720_1, 1920_1) couples the first reference voltage to the first output terminal according to the first data input, the first current mode drive unit (110, 210, 1310, 1410, 1710_1, 1910_1) outputs the first reference current from the first output terminal according to the first data input; and when the first voltage mode drive unit (120, 220, 520, 1320, 1420, 1720_1, 1920_1) couples the second reference voltage to the first output terminal according to the first data input, the first current mode drive unit (110, 210, 1310, 1410, 1710_1, 1910_1) receives the first reference current through the first output terminal according to the first data input.

3. The driver circuit of claim 1, **characterized in that** the first current mode drive unit (110, 210, 1310, 1410, 1710_1, 1910_1) comprises:
a current source, arranged for generating the first reference current, wherein the current source is selectively coupled to the first output terminal according to the first data input; and
a current sink, arranged for receiving the first reference current, wherein the current sink is selectively coupled to the first output terminal according to the first data input;
wherein when one of the current source and the current sink is coupled to the first output terminal according to the first data input, the other of the current source and the current sink is not coupled to the first output terminal.

4. The driver circuit of claim 3, **characterized in that** the current mode drive unit (110, 210, 1310, 1410, 1710_1, 1910_1) further comprises:
a first switch, selectively coupled between the current source and the first output terminal according to the first data input; and
a second switch, selectively coupled between the current sink and the first output terminal according to the first data input;
wherein when the first switch is switched on due to the first data input, the second switch is switched off; and
when the first switch is switched off due to the first data input, the second switch is switched on.

5. The driver circuit of claim 1, **characterized in that** the first voltage mode drive unit (120, 220, 520, 1320, 1420, 1720_1, 1920_1) comprises:
a first switch, selectively coupled between the first reference voltage and the first output terminal according to the first data input; and
a second switch, selectively coupled between the second reference voltage and the first output terminal according to the first data input;
wherein when the first switch is switched on due to the first data input, the second switch is switched off; and
when the first switch is switched off due to the first data input, the second switch is switched on.

6. The driver circuit of claim 1, **characterized in that** the first voltage mode drive unit (120, 220, 1320, 1420) comprises:
an impedance element, wherein one terminal of the impedance element is coupled to the first output terminal, and another terminal of the impedance element is coupled to the first reference voltage or coupled to the second reference voltage according to the first data input.

7. The driver circuit of claim 1, **characterized in that** the first voltage mode drive unit (120, 520, 1320, 1420) comprises:
a first impedance element, selectively coupled between the first reference voltage and the first output terminal according to the first data input; and
a second impedance element, selectively coupled between the second reference voltage and the first output terminal according to the first data input.
wherein when the first reference voltage is coupled to the first output terminal through the first impedance element according to the first data input, the second reference voltage is not coupled to the first output terminal; and
when the second reference voltage is coupled to the first output terminal through the second impedance element according to the first data input, the first reference voltage is not coupled to the first output terminal.

8. The driver circuit of claim 1, **characterized in that** the driver circuit is further arranged for receiving n-1 second data inputs, the driver circuit generates the output signal according to the first data input and the n-1 second data inputs, n is an integer greater than one, and the driver circuit further comprises:
n-1 second voltage mode drive units (1720_2, 1720_n, 1920_2, 1920_n), coupled to the first output terminal and controlled by the n-1 second data inputs respectively, wherein each second voltage mode drive unit (1720_2, 1720_n, 1920_2, 1920_n) couples one of the first reference voltage and the second reference voltage to the first output terminal according to a second data input corresponding to the second voltage mode drive unit.

9. The driver circuit of claim 1, **characterized in that** the driver circuit (1200) is further arranged for receiving n-1 second data inputs, the driver circuit (1200) generates the output signal according to the first data input and the n-1 second data inputs, n is an integer greater than one, and the driver circuit (1200) further comprises:
n-1 second current mode drive units (1230, 1240, 1710_2, 1710_n, 1910_2, 1910_n), coupled to the first output terminal and controlled by the n-1 second data inputs respectively, the n-1 second current mode drive units (1230, 1240, 1710_2, 1710_n, 1910_2, 1910_n) arranged for generating n-1 second reference currents respectively, wherein each second current mode drive unit (1230, 1240, 1710_2, 1710_n, 1910_2, 1910_n) selectively outputs a second reference current corresponding to the second current mode drive unit from the first output terminal to the termination element according to a second data input corresponding to the second current mode drive unit, and selectively receives the second reference current through the first output terminal according to the second data input.

10. The driver circuit of claim 1, **characterized in that** the driver circuit (100, 200, 500, 800, 900, 1000, 1002, 1100, 1200) further comprises:
a second output terminal, coupled to the first current mode drive unit (110, 210, 1910_1) and the first voltage mode drive unit (120, 220, 520, 1920_1), wherein the first output terminal and the second output terminal are used as a pair of differential output terminals (102), and arranged for outputting the output signal;
wherein the first current mode drive unit (110, 210, 1910_1) outputs the first reference current from one of the first output terminal and the second output terminal to the termination element according to the first data input, and receives the first reference current from the other of the first output terminal and the second output terminal according to the first data input; and the first voltage mode drive unit (120, 220, 520, 1920_1) couples the first reference voltage to one of the first output terminal and the second output terminal according to the first data input, and couples the second reference voltage to the other of the first output terminal and the second output terminal according to the first data input.

11. The driver circuit of claim 10, **characterized in that** the first reference voltage is greater than the second reference voltage; and when the first current mode drive unit (110, 210, 1910_1) outputs the first reference current from the first output terminal and receives the first reference current from the second output terminal according to the first data input, the first voltage mode drive unit (120, 220, 520, 1920_1) couples the first reference voltage to the first output terminal and couples the second reference voltage to the second output terminal according to the first data input.

12. The driver circuit of claim 10, **characterized in that** the driver circuit is further arranged for receiving n-1 second data inputs, the driver circuit generates the output signal according to the first data input and the n-1 second data inputs, n is an integer greater than one, and the driver circuit further comprises:
n-1 second voltage mode drive units (1920_2, 1920_n), coupled to the first output terminal and the second output terminal and controlled by the n-1 second data inputs respectively, wherein each second voltage mode drive unit (1920_2, 1920_n) couples the first reference voltage to one of the first output terminal and the second output terminal according to a second data input corresponding to the second voltage mode drive unit, and couples the second reference voltage to the other of the first output terminal and the second output terminal according to the second data input.

13. The driver circuit of claim 10, **characterized in that** the driver circuit (1200) is further arranged for receiving n-1 second data inputs, the driver circuit (1200) generates the output signal according to the first data input and the n-1 second data inputs, n is an integer greater than one, and the driver circuit (1200) further comprises:
n-1 second current mode drive units (1230, 1240, 1910_2, 1910_n), coupled to the first output terminal and the second output terminal and controlled by the n-1 second data inputs respectively, the n-1 second current mode drive units (1230, 1240, 1910_2, 1910_n) arranged for generating n-1 second reference currents respectively, wherein each second current mode drive unit (1230, 1240, 1910_2, 1910_n) outputs the first reference current from one of the first output terminal and the second output terminal to the termination element according to a second reference current corresponding to the second current mode drive unit, and receives the first reference current from the other of the first output terminal and the second output terminal according to the second data input.

14. The driver circuit of claim 8, 9, 12 or 13, **characterized in that** the output signal comprises n components generated in response to the first data input and the n-1 second data inputs respectively; the first data input and the n-1 second data inputs correspond to a binary code of n bits; and the n components of the output signal have a binary-weighted relationship.

15. The driver circuit of claim 8, 9, 12 or 13, **characterized in that** at least one of the n-1 second data input is an advanced signal or a delayed signal relative to the first data input.
